# EUROPÄISCHE PATENTSCHRIFT

(11) **EP 4 403 930 B1**
(45) Veröffentlichungstag und Bekanntmachung des Hinweises auf die Patenterteilung: **29.10.2025**
(21) Anmeldenummer: 23152652.6
(22) Anmeldetag: 20.01.2023
(51) Int. Cl.: G01R 19/00, G01R 21/133, G01R 22/06

(54) **VORRICHTUNG ZUM ERMITTELN DER ELEKTRISCHEN LEISTUNGSAUFNAHME EINES HAUSHALTSNETZES**
DEVICE FOR DETERMINING THE ELECTRICAL POWER CONSUMPTION OF A DOMESTIC NETWORK
DISPOSITIF DE DÉTERMINATION DE LA CONSOMMATION ÉLECTRIQUE D'UN RÉSEAU DOMESTIQUE

(43) Veröffentlichungstag der Anmeldung: 24.07.2024
(73) Patentinhaber: EET - Efficient Energy Technology GmbH, 8020 Graz (AT)
(72) Erfinder: JAVORIC, Haris, 8020 Graz (AT); MÜLLER, Markus, 8055 Graz (AT); WEINBERGER, Stephan, 8662 St. Barbara im Mürztal (AT)
(74) Vertreter: Weiser Voith Gugler Patentanwälte Partnerschaft

(56) Entgegenhaltungen:
- WO-A2-2012/065078
- US-A1- 2023 018 100

## Beschreibung

Die vorliegende Erfindung betrifft eine Vorrichtung zum Ermitteln der elektrischen Leistungsaufnahme eines mit einem Versorgungsnetz verbundenen Haushaltsnetzes mit mehreren Verbraucheranschlüssen. Die Vorrichtung umfasst eine an einen der Verbraucheranschlüsse anschließbare Koppeleinheit zum Einkoppeln von Messsignalen in den Verbraucheranschluss, eine an die Koppeleinheit angeschlossene Auswerteeinheit zum Erfassen jeweils einer Signalantwort zu jedem eingekoppelten Messsignal und zum Ermitteln der elektrischen Leistungsaufnahme aus den erfassten Signalantworten und eine mit der Koppeleinheit und der Auswerteeinheit verbundene Steuereinheit.

Zum Messen des elektrischen Energieverbrauchs eines Haushaltsnetzes wird im Allgemeinen ein Stromzähler eingesetzt. Der Stromzähler ist dem jeweiligen Haushaltsnetz vorgeschaltet, sodass die gesamte, von allen Verbrauchern des Haushaltsnetzes aufgenommene elektrische Energie den Stromzähler passieren muss. Solche Stromzähler sind Leistungsmessgeräte, welche die aufgenommene elektrische Leistung über die Zeit zu einer verbrauchten Energie aufsummieren und die Summe ablesbar machen.

Neuerdings werden anstelle der Stromzähler sogenannte "Smart Meter" verwendet, welche einzelne Leistungsmesswerte zu Messzeitpunkten aufzeichnen, nicht bloß aufsummieren. Aufgrund ihrer Messgenauigkeit und -auflösung sind Smart Meter in der Lage, einzelne Energieverbraucher im Haushaltsnetz zu identifizieren. Dem Haushalt werden die Messwerte aus einem Smart Meter vom Energieversorger jedoch, wenn überhaupt, bloß im Nachhinein und meist nicht mit allen Details übermittelt.

Um das Verbrauchsverhalten zu optimieren, wäre es vorteilhaft, den Momentanverbrauch, d.h. die momentane elektrische Leistungsaufnahme des Haushaltsnetzes, zu bestimmen. In der Folge können Verbraucher wie Beleuchtung, Waschmaschine, Haushaltselektronik od.dgl., deren Verbrauch einfach beeinflussbar ist, zeitversetzt eingesetzt werden, um hohe Spitzenlasten zu vermeiden und Kosten und Energie zu sparen. In manchen Haushalten ist ferner eine Speisevorrichtung zum Rückspeisen von Energie in das Haushaltsnetz vorgesehen, z.B. eine batteriegepufferte Solaranlage oder ein Batteriepuffer mit Wechselrichter. Der Einsatz einer solchen Speisevorrichtung ist besonders sinnvoll, um im Haushaltsnetz anfallende Spitzenlasten abzudecken; ein Rückspeisen in das Versorgungsnetz ist hingegen angesichts relativ niedriger Rückspeisetarife vielfach unerwünscht. In jedem dieser Fälle kommt der Einbau eines weiteren, dem Haushalt direkt zugänglichen Smart Meters zur Bestimmung der momentanen elektrischen Leistungsaufnahme aufgrund aufwändiger baulicher Maßnahmen meist nicht in Frage.

Aus der WO 2012/065078 A2 ist ein Messgerät bekannt, welches an einen Verbraucheranschluss im Haushaltsnetz angeschlossen wird und jederzeit die vom Haushaltsnetz gerade aufgenommene elektrische Leistung messen kann. Dazu koppelt das Messgerät ein Messsignal in den Verbraucheranschluss ein und errechnet daraus den augenblicklichen Leitwert des Haushaltsnetzes. Der Leitwert G (als komplexwertiger Leitwert auch: "Admittanz") ist der gesuchten elektrischen Leistung P bei konstanter Netzspannung V über die bekannte Beziehung P = V² * G proportional. Dabei werden Messsignale verschiedener Frequenzen, die deutlich über der Netzfrequenz liegen, eingekoppelt und daraus der Leitwert bei Netzfrequenz extrapoliert. Dieses Verfahren liefert eine brauchbare Grobabschätzung der elektrischen Leistungsaufnahme des Haushaltsnetzes, ist jedoch für manche Anwendungen zu wenig genau.

Aus der EP 3 364 156 B1 ist ein Verfahren zum Ermitteln eines Grundlastprofils eines Haushaltsnetzes auf Grundlage von Admittanzmessungen bekannt.

Die Erfindung setzt sich zum Ziel, eine Vorrichtung zu schaffen, welche ohne aufwändige bauliche Maßnahmen die elektrische Leistungsaufnahme eines Haushaltsnetzes zuverlässig und genauer als mit herkömmlichen Vorrichtungen ermitteln lässt.

Dieses Ziel wird durch eine Vorrichtung der einleitend genannten Art erreicht, welche sich erfindungsgemäß dadurch auszeichnet, dass die Auswerteeinheit über ein Bandpassfilter mit einstellbarer Mittenfrequenz an die Koppeleinheit angeschlossen ist, wobei die Steuereinheit mit dem Bandpassfilter verbunden und dazu ausgebildet ist, die Koppeleinheit zum Einkoppeln einer vorgegebenen Folge von Messsignalen unterschiedlicher Frequenz in den Verbraucheranschluss anzusteuern und die Mittenfrequenz des Bandpassfilters auf die Frequenz des jeweils eingekoppelten Messsignals einzustellen, und wobei die Auswerteeinheit dazu ausgebildet ist, die elektrische Leistungsaufnahme aus den zu den Messsignalen der Folge erfassten Signalantworten zu ermitteln.

Der Erfindung liegt die Erkenntnis zugrunde, dass ein maßgeblicher Grund für Ungenauigkeiten in der Ermittlung der elektrischen Leistungsaufnahme des Haushaltsnetzes in von den Verbrauchern erzeugten Störsignalen liegt, die in Haushaltsnetzen häufig, oft jedoch nur kurzzeitig, auftreten, erhebliche Signalamplituden erreichen und deshalb die Genauigkeit herkömmlicher Messverfahren deutlich einschränken. Das einstellbare Bandpassfilter filtert aufgrund seiner mit dem jeweiligen Messsignal übereinstimmenden Mittenfrequenz abliegende Störsignale zuverlässig aus und führt dadurch stets zu einer Verbesserung der Genauigkeit in der Ermittlung der Leistungsaufnahme, u.zw. unabhängig davon, ob die Leistungsaufnahme in Form einer Impedanz- oder Admittanzbestimmung, auf Grundlage eines Effektivwerts der Signalantwort oder auf andere Weise ermittelt wird. Die ermittelte Leistungsaufnahme kann z.B. als Augenblickswert, zum Ermitteln eines Grundlastprofils und/oder zum Ermitteln einer Abweichung von einem zuvor ermittelten Grundlastprofil verwendet werden.

Die Abläufe beim Einkoppeln der Messsignale und Erfassen der Signalantworten können unterschiedlich sein. In einer vorteilhaften ersten Ausführungsform ist die Auswerteeinheit zum Erfassen der Netzspannung des Haushaltsnetzes an den Verbraucheranschluss anschließbar und dazu ausgebildet, zu jedem Messsignal der Folge die Signalantwort jeweils in einem Zeitpunkt zu erfassen, in dem die erfasste Netzspannung eine vorgegebene Phasenlage hat. Auf diese Weise können Abweichungen in aufeinanderfolgenden Messvorgängen vermieden werden, die darauf beruhen, dass die Messsignale in Zeitpunkten verschiedener Phase bzw. Amplitude der Netzspannung erfasst werden. Dies ermöglicht eine besonders gute Vergleichbarkeit der ermittelten elektrischen Leistungsaufnahme.

Bevorzugt ist dabei die Steuereinheit dazu ausgebildet, die Koppeleinheit so anzusteuern, dass sie jedes Messsignal der Folge jeweils über lediglich eine vorgegebene erste Zeitspanne einkoppelt, welche einem die genannte Phasenlage umfassenden vorgegebenen Abschnitt einer Periode der Netzspannung entspricht. Durch geeignete Wahl des Abschnittslänge kann einerseits ein möglicher Einschwingvorgang der Signalantwort abgewartet und andererseits die Dauer jedes Messsignals und somit der gesamten Folge von Messsignalen kurz gehalten werden. Die Signalantworten zu allen Messsignalen der Folge sind so zum Ermitteln der Leistungsaufnahme innerhalb kurzer Zeit erfassbar. Dies reduziert die Wahrscheinlichkeit von Änderungen in der Leistungsaufnahme des Haushaltsnetzes deutlich, die während des Erfassens auftreten und das Ermitteln erschweren bzw. das Ergebnis verzerren.

Besonders günstig ist, wenn die Frequenzen der Messsignale der Folge über einen Frequenzbereich von 5 kHz bis 120 kHz, bevorzugt einen Frequenzbereich von 10 kHz bis 40 kHz, verteilt sind und einen gegenseitigen Signalabstand zwischen 50 Hz und 600 Hz, bevorzugt zwischen 100 Hz und 360 Hz, haben. Auf diese Weise wird der genannte Frequenzbereich durch Messsignale in z.B. gleichmäßig verteilten Schritten vollständig durchlaufen, was zu einer guten Abbildung der Leistungsaufnahme führt und die Identifikation einzelner Verbraucher im Haushaltsnetz erleichtert, ähnlich wie dies bei einer kontinuierlichen Frequenzänderung ("Sweep") des Messignals der Fall wäre jedoch mit vereinfachter, stufenweiser Steuerung des Bandpassfilters.

In einer zur genannten ersten Ausführungsform alternativen oder zusätzlichen zweiten Ausführungsform ist die Steuereinheit dazu ausgebildet, die Koppeleinheit so anzusteuern, dass sie jedes Messsignal der Folge jeweils über eine vorgegebene zweite Zeitspanne einkoppelt, welche mehreren Perioden der Netzspannung entspricht, wobei die Auswerteeinheit dazu ausgebildet ist, zu jedem Messsignal der Folge die Signalantwort jeweils über die genannte zweite Zeitspanne zu erfassen. Dies erleichtert eine detaillierte Analyse jeder Signalantwort und erlaubt somit ebenfalls hohe Genauigkeit beim Ermitteln der Leistungsaufnahme.

In einer vorteilhaften Variante der zweiten Ausführungsform ist zur Vereinfachung des Ermittelns der Leistungsaufnahme die Auswerteeinheit dazu ausgebildet, die zu den Messsignalen der Folge erfassten Signalantworten mithilfe einer Fourier-Transformation in jeweilige Signalantwortspektren zu transformieren. Anhand der Signalantwortspektren kann die Signalform der jeweiligen Signalantwort besonders effektiv analysiert und daraus die elektrische Leistungsaufnahme ermittelt werden. Besonders vorteilhaft ist dabei, wenn die Auswerteeinheit dazu ausgebildet ist, die elektrische Leistungsaufnahme anhand der Scheitelwerte der Signalantwortspektren zu ermitteln. Die Konzentration auf aussagekräftige Scheitelwerte der Signalantwortspektren macht das Ermitteln der Leistungsaufnahme einfach und effizient.

Günstig ist dabei, wenn die Frequenzen der Messsignale der Folge über einen Frequenzbereich von 5 kHz bis 120 kHz, bevorzugt einen Frequenzbereich von 10 kHz bis 40 kHz, verteilt sind und einen gegenseitigen Signalabstand von mehreren Kilohertz haben. Bevorzugt liegen die Frequenzen der Messsignale der Folge bei 15 kHz, 20 kHz, 24 kHz, 28 kHz und 32 kHz. So kann, obwohl jedes Messsignal der Folge über mehrere Perioden der Netzspannung eingekoppelt wird, die Messdauer über die gesamte Folge kurz und folglich die Wahrscheinlichkeit störender zwischenzeitlicher Änderungen in der Leistungsaufnahme gering gehalten werden. Dennoch ist der Frequenzbereich durch die genannten Frequenzen weitgehend und annähernd gleichmäßig abgedeckt. Eine Synchronisation mit der Netzfrequenz erfolgt dabei z.B. im Nulldurchgang der Netzspannung.

In einer vorteilhaften Ausführungsform ist die Steuereinheit ferner dazu ausgebildet, die Mittenfrequenz des Bandpassfilters aufeinanderfolgend auf die Frequenzen der Folge von Messsignalen einzustellen, ohne die Koppeleinheit zum Einkoppeln eines Messsignals anzusteuern, und ist die Auswerteeinheit dazu ausgebildet, für jede Mittenfrequenz jeweils ein Störsignal im Haushaltsnetz zu erfassen und zu speichern und beim Ermitteln der elektrischen Leistungsaufnahme zu berücksichtigen. Störsignale, die in Haushaltsnetzen stets auftreten und sich laufend verändern, können auf diese Weise rasch und genau erfasst werden. Sie können dann einerseits in Form einer Korrektur der zur entsprechenden Frequenz jeweils erfassten Signalantwort berücksichtigt werden. Alternativ oder ergänzend ist günstig, wenn die Steuereinheit dazu ausgebildet ist, in der Folge von Messsignalen jene Messsignale zu überspringen, bei deren Frequenz ein Störsignal mit einer einen vorgegebenen Grenzwert überschreitenden Signalamplitude erfasst wurde, um auf diese Weise das erfasste Störsignal beim Ermitteln der elektrischen Leistungsaufnahme zu berücksichtigen. Frequenzen, die besonders stark von Störungen belastet sind, werden somit beim Erfassen und Ermitteln der Leistungsaufnahme ausgeblendet und können das Ergebnis des Ermittelns nicht verfälschen.

Die Koppeleinheit und die Auswerteeinheit können auf verschiedene Weise aufgebaut sein. Vorteilhaft ist, wenn die Koppeleinheit einen Signalgenerator zum Erzeugen der Messsignale und eine an diesen angeschlossene Koppelschaltung zum Einkoppeln der erzeugten Messsignale in den Verbraucheranschluss aufweist. Signalgeneratoren sind einfach in der Handhabung und Steuerung und liefern über weite Frequenzbereiche präzise Ausgangssignale, die als Messsignale besonders geeignet sind. Die Koppelschaltung verbindet den Signalgenerator derart mit dem Verbraucheranschluss, dass die Messsignale eingekoppelt werden können und zugleich der Ausgang des Signalgenerators vor der elektrischen Leistung des Haushaltsnetzes geschützt wird.

Besonders günstig ist, wenn die Koppelschaltung einen Transformator mit einer an den Verbraucheranschluss anschließbaren Netzseite und einer mit dem Signalgenerator, einem ersten Kondensator und einem Messwiderstand in Serie geschalteten Speiseseite aufweist. So kann - im Fall eines Trenntransformators - der Signalgenerator galvanisch vom Haushaltsnetz getrennt werden. Zugleich unterdrückt der erste Kondensator Gleichstromanteile und Gleichspannungen. Der Messwiderstand dient als Shunt zum Erfassen einer Strom-Signalantwort auf ein eingekoppeltes Spannungs-Messsignal des Signalgenerators. Es versteht sich, dass alternativ ein Strom-Messsignal in den Verbraucheranschluss eingekoppelt und die resultierende Spannungs-Signalantwort erfasst werden könnte.

Bevorzugt ist ferner der Netzseite des Transformators ein zweiter Kondensator in Serie geschaltet. Der zweite Kondensator erhöht die netzseitige Impedanz und schützt auf diese Weise den Signalgenerator vor der Netzleistung. Überdies kann mithilfe der beiden Kondensatoren die Bandbreite eingestellt werden, innerhalb welcher Messsignalen in den Verbraucheranschluss eingekoppelt werden können.

In einer bevorzugten Ausführungsform ist das Bandpassfilter ein Switched-Capacitor-Filter. Switched-Capacitor-Filter sind besonders einfach und präzise zu steuern und haben geringe Baugröße.

Die Erfindung wird nachfolgend anhand von in den beigeschlossenen Zeichnungen dargestellten Ausführungsbeispielen näher erläutert. In den Zeichnungen zeigen:
Fig. 1 ein elektrisches Netz mit einer erfindungsgemäßen Messvorrichtung in einem schematischen Ersatzschaltbild;
Fig. 2 die Messvorrichtung von Fig. 1 in einem Blockschaltbild mit einzelnen Bauteilen;
die Fig. 3a bis 3d eine Netzspannung eines Haushaltsnetzes mit überlagerter Messsignal-Spannung der Messvorrichtung von Fig. 1 in einem Diagramm über der Zeit (Fig. 3a), von der Messvorrichtung von Fig. 1 erfasste Signalantworten auf Messsignale in Form von Effektivwerten (Fig. 3b), Phasenwinkel zwischen den Messsignalen und den Signalantworten (Fig. 3c) und von der Messvorrichtung von Fig. 1 erfasste Störsignale in Form von Effektivwerten (Fig. 3d), jeweils in einem Diagramm über der Frequenz; und
die Fig. 4a und 4b eine von der Messvorrichtung von Fig. 1 erfasste Signalantwort in Form des Effektivwerts in einem Diagramm über der Zeit (Fig. 4a) und nach Fourier-Transformation in einem Diagramm über der Frequenz (Fig. 4b).

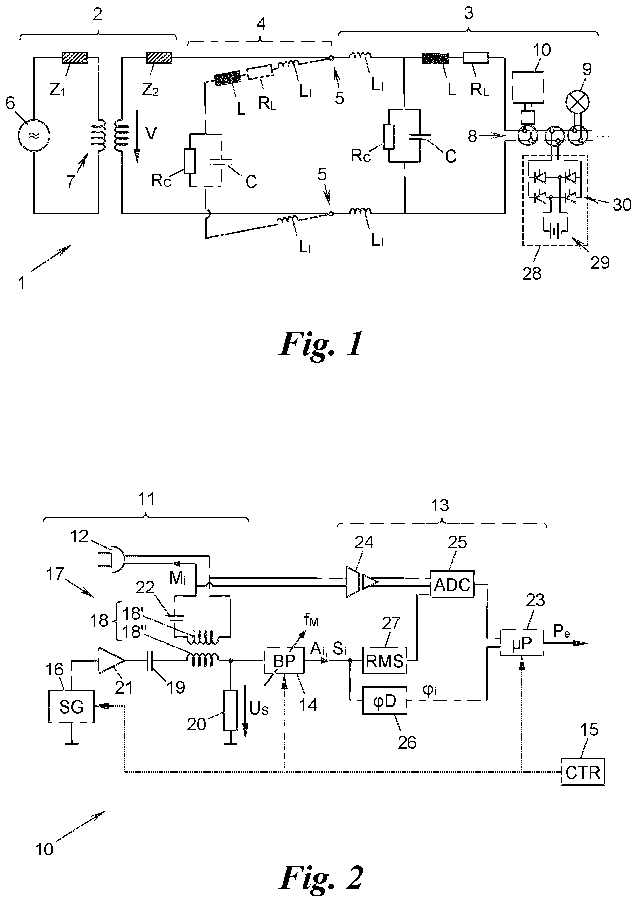

Gemäß Fig. 1 umfasst ein elektrisches Netz 1 ein Versorgungsnetz 2, mit welchem ein Haushaltsnetz 3 und zumindest ein weiteres Haushaltsnetz 4 über Anbindungen 5 verbunden sind. Das Versorgungsnetz 2 hat eine Energiequelle 6, z.B. einen Generator, einen Transformator 7 und sowohl hoch- als auch niederspannungsseitig jeweils eine Leitungsimpedanz Z₁, Z₂ in dem Ersatzschaltbild von Fig. 1.

Das Haushaltsnetz 3 ist - wie ebenso weitere Haushaltsnetze 4 - in dem beispielhaften Ersatzschaltbild von Fig. 1 durch eine Induktivität L mit Wirkanteil R_{L} und eine Kapazität C mit parallelem Wirkanteil R_{C} versinnbildlicht. An den Anbindungen 5 hat das Haushaltsnetz 3 ferner Eingangsinduktivitäten L_{I}, welche beispielsweise von einem Fehlerstromschutzschalter herrühren. Das Haushaltsnetz 3 hat mehrere Verbraucheranschlüsse 8, mit welchen verschiedene elektrische Verbraucher 9 des Haushaltsnetzes 3 und im Beispiel der Fig. 1 ferner eine Vorrichtung 10, hier auch "Messvorrichtung" genannt, zum Ermitteln der elektrischen Leistungsaufnahme Pₑ des Haushaltsnetzes 3 verbunden sind.

Die Vorrichtung 10 hat gemäß Fig. 2 eine Koppeleinheit 11, die z.B. mit einem Stecker 12 an einen der Verbraucheranschlüsse 8 des Haushaltsnetzes 3 angeschlossen werden kann, um Messsignale M in den Verbraucheranschluss 8 ein- und zugehörige Signalantworten A auszukoppeln. Die Vorrichtung 10 umfasst ferner eine Auswerteeinheit 13, um die zu jedem eingekoppelten Messsignal M jeweils zugehörige Signalantwort A zu erfassen und aus den erfassten Signalantworten A die elektrische Leistungsaufnahme Pₑ des Haushaltsnetzes 3 zu ermitteln.

Die Auswerteeinheit 13 ist über ein Bandpassfilter 14 der Vorrichtung 10 an die Koppeleinheit 11 angeschlossen. Das Bandpassfilter 14 hat eine einstellbare Mittenfrequenz f_{M} und kann beliebiger Bauart und Ordnung sein, z.B. zweiter oder höherer Ordnung. In der dargestellten Ausführungsform ist das Bandpassfilter 14 ein Switched-Capacitor-Filter. Ferner verfügt die Vorrichtung 10 über eine Steuereinheit 15, die mit der Koppeleinheit 11, der Auswerteeinheit 13 und dem Bandpassfilter 14 verbunden ist, um diese anzusteuern.

Um die elektrische Leistungsaufnahme Pₑ des Haushaltsnetzes 3 zu ermitteln, steuert die Steuereinheit 15 die Koppeleinheit 11 so an, dass diese eine vorgegebene Folge von Messsignalen M₁, M₂, ..., allgemein Mᵢ, unterschiedlicher Frequenz F₁, F₂, ..., allgemein Fᵢ, in den Verbraucheranschluss 8 einkoppelt. Die Messsignale Mᵢ sind optional - jedoch nicht zwingend - sinusförmig. Synchron dazu stellt die Steuereinheit 15 die Mittenfrequenz f_{M} des Bandpassfilters 14 auf die Frequenz Fᵢ des jeweils eingekoppelten Messsignals Mᵢ ein. Die zu den jeweiligen Messsignalen Mᵢ der Folge {Mᵢ} von der Auswerteeinheit 13 erfassten Signalantworten A₁, A₂, ..., allgemein Aᵢ, passieren, soweit ihre Frequenz der Frequenz Fᵢ des zugehörigen Messsignals Mᵢ entspricht, jeweils das mit seiner Mittenfrequenz f_{M} auf diese Frequenz Fᵢ eingestellte Bandpassfilter 14 ungehindert, bevor sie von der Auswerteeinheit 13 erfasst werden. Allfällige Störsignale S anderer Frequenz als der Frequenz Fᵢ werden vom Bandpassfilters 14 - je nach ihrem Abstand von der Mittenfrequenz f_{M} und der Ordnung des Bandpassfilters 14 - zumindest teilweise herausgefiltert. Aus den erfassten Signalantworten Aᵢ ermittelt die Auswerteeinheit 13 die elektrische Leistungsaufnahme Pₑ des Haushaltsnetzes 3, wie weiter unten näher erläutert wird.

Die Koppeleinheit 11 kann das Messsignal M in jeder im Stand der Technik bekannten Art und Weise erzeugen und in den Verbraucheranschluss 8 einkoppeln. In der in Fig. 2 dargestellten Ausführungsform weist die Koppeleinheit 11 einen Signalgenerator 16 und eine an den Signalgenerator 16 angeschlossene Koppelschaltung 17 auf. In diesem Beispiel hat die Koppelschaltung 17 einen Transformator 18 mit einer an den Verbraucheranschluss 8 anschließbaren Netzseite 18' und einer mit dem Signalgenerator 16, einem ersten Kondensator 19 und einem Messwiderstand 20 in Serie geschalteten Speiseseite 18". Je nach Ausgangsleistung des Signalgenerator 16 können ferner an der Netzseite 18' und/oder (wie hier) an der Speiseseite 18" des Transformators 18 ein optionaler Verstärker 21 angeordnet sein.

Der Transformator 18 kann als Spartransformator oder, wie dargestellt, als Trenntransformator zur zusätzlichen galvanischen Trennung zwischen Netz- und Speiseseite 18', 18" ausgebildet sein. Je nach Ausführung des Signalgenerators 16 bzw. Koppeleinheit 11 kann der Transformator 18 auch entfallen.

Der erste Kondensator 19 unterdrückt Gleichstromanteile und Gleichspannungen. Optional kann die Netzseite 18' des Transformators 18 mit einem zweiten Kondensator 22 in Serie geschaltet sein und so die Koppelschaltung 17 ergänzen. Der zweite Kondensator 22 erhöht die Impedanz der Koppelschaltung 17. Der erste und zweite Kondensator 19, 22 bestimmen ferner gemeinsam die Bandbreite der Koppelschaltung 17, innerhalb welcher die Messsignale Mᵢ wirksam in den Versorgungsanschluss 8 eingekoppelt werden können.

Am Messwiderstand 20 werden im Beispiel der Fig. 2 die Signalantworten Aᵢ, welche sich infolge der eingekoppelten Messsignale Mᵢ ausbilden, jeweils als Spannung Uₛ erfasst. Alternativen zum Einkoppeln einer Folge {Mᵢ} von Messsignalen Mᵢ und zum Erfassen zugehöriger Signalantworten Aᵢ sind dem Fachmann bekannt und könnten ebenso eingesetzt werden.

Die Auswerteeinheit 12 hat im dargestellten Beispiel einen Prozessor 23, welcher aus der erfassten Signalantworten Aᵢ die elektrische Leistungsaufnahme Pₑ ermittelt, u.zw. je nach Erfordernis direkt in Form einer elektrischen Leistung P oder äquivalent dazu z.B. eines elektrischen Leitwerts G, insbesondere eines komplexwertigen Leitwerts ("Admittanz"), welcher über die bekannte Beziehung P = V² * G der Netzspannung V proportional ist. Zum Erfassen der Netzspannung V ist optional die Auswerteeinheit 13 - hier: über einen Trennverstärker 24 - an den Verbraucheranschluss 8 des Haushaltsnetzes 3 angeschlossen. Einerseits kann die erfasste Netzspannung V - z.B. in Form ihres Effektivwerts - zum Ermitteln der elektrischen Leistungsaufnahme Pₑ des Haushaltsnetzes 3 herangezogen und andererseits die Auswerteeinheit 13 und/oder die Koppeleinheit 11 in Abhängigkeit von der erfassten Netzspannung V gesteuert werden, d.h. das Erfassen der Signalantworten Aᵢ und/oder das Einkoppeln der Messsignale Mᵢ mit dem Verlauf der Netzspannung V zeitlich abgestimmt werden.

Im Beispiel der Fig. 2 verfügt die Auswerteeinheit 13 optional über einen Analog-Digital-Wandler 25, einen Phasendetektor 26 zur Detektion eines Phasenwinkels φ₁, φ₂, ..., allgemein φᵢ, zwischen den jeweiligen Messsignalen Mᵢ und ihren Signalantworten Aᵢ und einen Block 27 zur Effektivwertbildung, falls die Signalantworten Aᵢ in Form von Effektivwerten erfasst werden. Der Block 27 zur Effektivwertbildung und ebenso der Phasendetektor 26 können beispielsweise separate Hardware-Bausteine oder z.B. im Prozessor 23 ausgeführte Software-Bausteine sein. Ähnlich könnte die Steuereinheit 15 als Software-Baustein z.B. im Prozessor 23 oder als davon separater Hardware-Baustein ausgebildet sein.

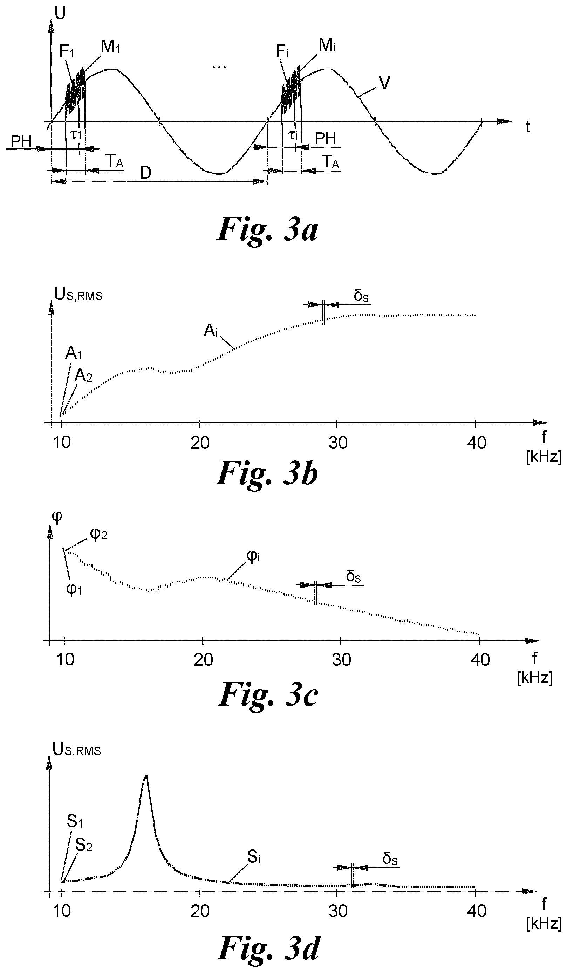

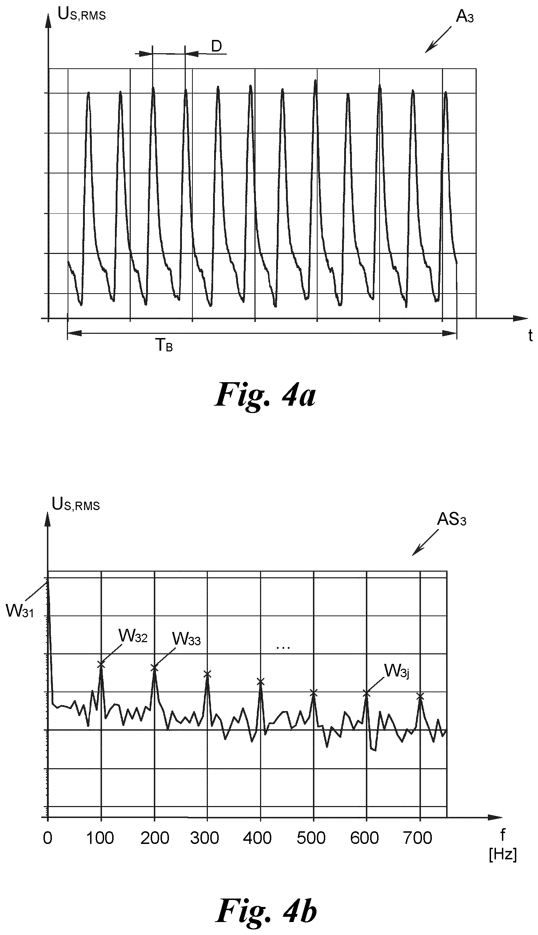

Anhand der Darstellungen in den Fig. 3a bis 3d bzw. 4a und 4b soll im Folgenden das Ermitteln der elektrischen Leistungsaufnahme Pₑ des Haushaltsnetzes 3 anhand einer ersten bzw. einer zur ersten alternativen oder ergänzenden zweiten Ausführungsform der Messvorrichtung 10 näher erläutert werden.

Das Diagramm der Fig. 3a zeigt einen beispielhaften Zeitverlauf der Netzspannung V mit einer Periode D von 20 ms, d.h. bei 50 Hz Netzfrequenz. Die Netzspannung V ist im dargestellten Beispiel aufgrund der angeschlossenen Verbraucher 9, möglicher Störungen etc. nicht exakt sinusförmig.

Am Verbraucheranschluss 8 koppelt die von der Steuereinheit 15 angesteuerte Koppeleinheit 11 jedes Messsignal Mᵢ der Folge {Mᵢ} jeweils über lediglich eine vorgegebene erste Zeitspanne T_{A} ein. In Fig. 3a ist die Spannungsamplitude des Messsignals Mᵢ zur besseren Sichtbarkeit deutlich überhöht dargestellt; tatsächlich liegt diese in der Größenordnung von z.B. einigen Zehntel Volt bis einigen Volt. Die Zeitspanne T_{A} kann über mehrere Perioden D der Netzspannung V gehen; um Zeit zu sparen, wird hier hingegen die erste Zeitspanne T_{A} derart vorgegeben, dass sie lediglich einem Abschnitt, d.h. einem Bruchteil, der Periode D der Netzspannung V entspricht. Die Auswerteeinheit 13 erfasst dabei zu jedem Messsignal Mᵢ der Folge {Mᵢ} die Signalantwort Aᵢ jeweils in einem Zeitpunkt τ₁, τ₂, ..., allgemein τᵢ, in welchem die Netzspannung V eine vorgegebene Phasenlage PH hat, d.h. τᵢ₊₁ = τᵢ + D. Es versteht sich, dass der genannten Abschnitt der Periode D diese Phasenlage PH jeweils enthält.

In Fig. 3b ist jede Signalantwort Aᵢ als Effektivwert, d.h. als quadratischer Mittelwert ("Root Mean Square", RMS), der am Messwiderstand 20 jeweils im Messzeitpunkt τᵢ erfassten Spannung Uₛ über der Frequenz Fᵢ des jeweiligen Messsignals Mᵢ dargestellt. Die Frequenzen Fᵢ der Messsignale Mᵢ der Folge {Mᵢ} sind dabei optional über einen Frequenzbereich von 5 kHz bis 120 kHz verteilt, im vorliegenden Beispiel über den Frequenzbereich von 10 kHz bis 40 kHz. Um eine gute Auflösung in den erfassten Signalantworten Aᵢ zu erzielen, sodass die elektrische Leistungsaufnahme Pₑ präzise ermittelt werden kann, haben die Frequenzen Fᵢ der Messsignale Mᵢ der Folge {Mᵢ} einen gegenseitigen Signalabstand δₛ, der z.B. zwischen 50 Hz und 600 Hz liegt, bevorzugt zwischen 100 Hz und 360 Hz, im dargestellten Beispiel bei 200 Hz. Der Abstand δₛ benachbarter Messwerte in Fig. 3a beträgt in diesem Beispiel also 200 Hz.

Gemäß Fig. 3c kann, um das Ermitteln der elektrischen Leistungsaufnahme Pₑ zu unterstützen, optional zu jeder Signalantwort Aᵢ auch der Phasenwinkel φᵢ gegenüber dem zugrundeliegenden Messsignal Mᵢ erfasst werden. Anhand der Phasenwinkel φᵢ kann z.B. festgestellt werden, ob im Haushaltsnetz 3 überwiegend induktive oder kapazitive Verbraucher 9 aktiv sind, und andererseits zusammen mit den erfassten Messspannungen Uₛ (Fig. 3b) die komplexe Admittanz ermittelt werden.

Fig. 3d zeigt ein Spektrum von Störsignalen S₁, S₂, ..., allgemein Sᵢ, im Haushaltsnetz 3. Um dieses zu erfassen, ist optional die Steuereinheit 15 auch dazu ausgebildet, die Mittenfrequenz f_{M} des Bandpassfilters 14 aufeinanderfolgend jeweils auf eine der Frequenzen Fᵢ der Folge {Mᵢ} von Messsignalen Mᵢ einzustellen, ohne dass die Koppeleinheit 11 ein Messsignal Mᵢ in den Verbraucheranschluss 8 einkoppelt. Die Auswerteeinheit 13 erfasst dabei - z.B. wieder am Messwiderstand 20 - für jede der Mittenfrequenzen f_{M} jeweils ein Störsignal Sᵢ im Haushaltsnetz 3, speichert dieses und berücksichtigt es beim Ermitteln der elektrischen Leistungsaufnahme Pₑ.

Auch die Störsignale Sᵢ sind im Beispiel der Fig. 3d als Effektivwerte dargestellt. Beim Ermitteln der elektrischen Leistungsaufnahme Pₑ können die Störsignale Sᵢ beispielsweise berücksichtigt werden, indem sie von den jeweiligen Effektivwerten der Signalantworten Aᵢ (Fig. 3b) gleicher Frequenzen Fᵢ abgezogen werden. Alternativ oder ergänzend können die Störsignale Sᵢ z.B. dadurch berücksichtigt werden, dass die Steuereinheit 15 jene Messsignale Mᵢ der Folge {Mᵢ} überspringt, bei deren Frequenz Fᵢ ein Störsignal Sᵢ mit einer einen vorgegebenen Grenzwert überschreitenden Signalamplitude erfasst wurde; anstelle der Signalamplitude kann gleichwertig z.B. der Effektivwert des Störsignals Sᵢ od.dgl. herangezogen werden.

Die elektrische Leistungsaufnahme Pₑ des Haushaltsnetzes 3 kann dann auf verschiedene Weise insbesondere vom Prozessor 23 der Auswerteeinheit 13 ermittelt werden, z.B. anhand von Vergleichstabellen ähnlicher Haushaltsnetze 4 oder anhand von vorbekannten Admittanz-Spektren zumindest der wesentlichen Verbraucher 9 im Haushaltsnetz 3 durch numerische Optimierung für jede Signalantwort Aᵢ, sodass der Betrieb zumindest dieser Verbraucher 9 detektiert wird, etc. Die optional erfassten Phasenwinkel φᵢ, Störsignale Sᵢ und/oder die erfasste Netzspannung V werden dabei je nach Bedarf und Verfügbarkeit berücksichtigt.

Angemerkt sei, dass jede Signalantwort Aᵢ naturgemäß die Antwort des (gesamten) elektrischen Netzes 1 - nicht wie eigentlich gewünscht bloß des Haushaltsnetzes 3 - auf das jeweilige Messsignal Mᵢ am Verbraucheranschluss 8 ist. Dank der Eingangsinduktivitäten L_{I} kann jedoch bei geeignet hohen Frequenzen Fᵢ der Messsignale Mᵢ der verfälschende Einfluss des Versorgungsnetzes 2 und weiterer Haushaltsnetze 4 auf die Signalantworten Aᵢ entscheidend eingeschränkt werden, wie dem Fachmann bekannt ist, sodass die Signalantworten Aᵢ ausreichend genau die Eigenschaften des Haushaltsnetzes 3 widerspiegeln.

In der zweiten Ausführungsform gemäß den Fig. 4a und 4b steuert die Steuereinheit 15 die Koppeleinheit 11 derart an, dass die Koppeleinheit 11 jedes Messsignal Mᵢ der Folge (Mᵢ) über eine vorgegebene zweite Zeitspanne T_{B} in den Verbraucheranschluss 8 einkoppelt. Die Zeitspanne T_{B} entspricht dabei einer - optional ganzzahligen - Vielzahl von Perioden D, d.h. mehreren Perioden D, der Netzspannung V (im Beispiel der Fig. 4a: zwölf Perioden D). Die Auswerteeinheit 13 erfasst in diesem Fall zu jedem Messsignal Mᵢ der Folge {Mᵢ} die Signalantwort Aᵢ jeweils über die genannte zweite Zeitspanne T_{B}, wie dies in Fig. 4a für eine Signalantwort A₃ dargestellt ist.

Die elektrische Leistungsaufnahme Pₑ kann dann anhand der erfassten Signalantworten Aᵢ ermittelt werden, z.B. aus den Amplituden der Spannung Uₛ am Messwiderstand 20 bei den verschiedenen Frequenzen Fᵢ der Messsignale Mᵢ der Folge {Mᵢ} und/oder aus den Signalformen der Signalantworten Aᵢ od.dgl. Wieder können dabei die optional erfassten Phasenwinkel φᵢ, Störsignale Sᵢ und/oder die erfasste Netzspannung V je nach Bedarf und Verfügbarkeit berücksichtigt werden.

Alternativ dazu transformiert gemäß Fig. 4b die Auswerteeinheit 13 - z.B. ihr Prozessor 23 - die zu den Messsignalen Mᵢ der Folge (Mᵢ) erfassten Signalantworten Aᵢ mithilfe einer Fourier-Transformation in jeweilige Signalantwortspektren ASᵢ, welche dann zum Ermitteln der Leistungsaufnahme Pₑ herangezogen werden, z.B. indem die elektrische Leistungsaufnahme Pₑ anhand der signifikanten Scheitelwerte Wᵢ₁, Wᵢ₂, ..., allgemein Wᵢⱼ (hier: W₃ⱼ), der Signalantwortspektren ASᵢ ermittelt wird.

Auch in der genannten zweiten Ausführungsform sind die Frequenzen Fᵢ der Messsignale Mᵢ der Folge {Mᵢ} beispielsweise über den Frequenzbereich von 5 kHz bis 120 kHz verteilt, bevorzugt über den Frequenzbereich von 10 kHz bis 40 kHz, jedoch haben sie optional einen gegenseitigen Signalabstand δₛ von mehreren Kilohertz (kHz). In einer Variante dieser Ausführungsform liegen die Frequenzen Fᵢ der Messsignale Mᵢ der Folge {Mᵢ} bei 15 kHz, 20 kHz, 24 kHz, 28 kHz und 32 kHz.

In der zweiten Ausführungsform erfolgt das Ermitteln der elektrischen Leistungsaufnahme Pₑ ebenso anhand von Vergleichstabellen und/oder anhand von vorbekannten Admittanz-Spektren, wie diese weiter oben in Bezug auf die erste Ausführungsform erläutert wurden. Alternativ können z.B. die Scheitelwerte Wᵢⱼ der Signalantwortspektren ASᵢ einem anhand einer Vielzahl von Haushaltsnetzen 3, 4 trainierten Maschinenlernmodell zugeführt werden, welches daraus die elektrische Leistungsaufnahme Pₑ des Haushaltsnetzes 3 ermittelt. Dasselbe wäre auch für die vorgenannte erste Ausführungsform möglich, z.B. anhand der in Fig. 3b dargestellten Signalantworten Aᵢ und/oder anhand der in Fig. 3c dargestellten Phasenwinkel φᵢ.

Zurückkommend auf Fig. 1 ist optional an das Haushaltsnetz 3 eine Speisevorrichtung 28 mit Pufferspeicher 29 und Wechselrichter 30, z.B. eine batteriegepufferte Solaranlage oder ein anderer geregelter Energiespeicher, angeschlossen und mit der Steuereinheit 15 oder der Auswerteeinheit 13 verbunden. Die Steuereinheit 15 oder die Auswerteeinheit 13 aktiviert die Speisevorrichtung 28, wenn die ermittelte elektrischen Leistungsaufnahme Pₑ des Haushaltsnetzes 3 eine vorgegebene Speiseleistung der Speisevorrichtung 28 überschreitet, und deaktiviert die Speisevorrichtung 28 andernfalls.

Die Erfindung ist nicht auf die dargestellten Ausführungsformen beschränkt, sondern umfasst alle Varianten, Modifikationen und deren Kombinationen, die in den Rahmen der angeschlossenen Ansprüche fallen.

## Patentansprüche

1. Vorrichtung (10) zum Ermitteln der elektrischen Leistungsaufnahme (Pₑ) eines mit einem Versorgungsnetz (2) verbundenen Haushaltsnetzes (3) mit mehreren Verbraucheranschlüssen (8), umfassend:
eine an einen der Verbraucheranschlüsse (8) anschließbare Koppeleinheit (11) zum Einkoppeln von Messsignalen (M) in den Verbraucheranschluss (8),
eine an die Koppeleinheit (11) angeschlossene Auswerteeinheit (13) zum Erfassen jeweils einer Signalantwort (A) zu jedem eingekoppelten Messsignal (M) und zum Ermitteln der elektrischen Leistungsaufnahme (Pₑ) aus den erfassten Signalantworten (A), und
eine mit der Koppeleinheit (11) und der Auswerteeinheit (13) verbundene Steuereinheit (15),
**dadurch gekennzeichnet, dass**
die Auswerteeinheit (13) über ein Bandpassfilter (14) mit einstellbarer Mittenfrequenz (f_{M}) an die Koppeleinheit (11) angeschlossen ist,
wobei die Steuereinheit (15) mit dem Bandpassfilter (14) verbunden und dazu ausgebildet ist, die Koppeleinheit (11) zum Einkoppeln einer vorgegebenen Folge von Messsignalen (Mᵢ) unterschiedlicher Frequenz (Fᵢ) in den Verbraucheranschluss (8) anzusteuern und die Mittenfrequenz (f_{M}) des Bandpassfilters (14) auf die Frequenz (Fᵢ) des jeweils eingekoppelten Messsignals (Mᵢ) einzustellen, und
wobei die Auswerteeinheit (13) dazu ausgebildet ist, die elektrische Leistungsaufnahme (Pₑ) aus den zu den Messsignalen (Mᵢ) der Folge erfassten Signalantworten (Aᵢ) zu ermitteln.

2. Vorrichtung nach Anspruch 1, **dadurch gekennzeichnet, dass** die Auswerteeinheit (13) zum Erfassen der Netzspannung (V) des Haushaltsnetzes (3) an den Verbraucheranschluss (8) anschließbar und dazu ausgebildet ist, zu jedem Messsignal (Mᵢ) der Folge die Signalantwort (Aᵢ) jeweils in einem Zeitpunkt (τᵢ) zu erfassen, in dem die erfasste Netzspannung (V) eine vorgegebene Phasenlage (PH) hat.

3. Vorrichtung nach Anspruch 2, **dadurch gekennzeichnet, dass** die Steuereinheit (15) dazu ausgebildet ist, die Koppeleinheit (11) so anzusteuern, dass sie jedes Messsignal (Mᵢ) der Folge jeweils über lediglich eine vorgegebene erste Zeitspanne (T_{A}) einkoppelt, welche einem die genannte Phasenlage (PH) umfassenden vorgegebenen Abschnitt einer Periode (D) der Netzspannung (V) entspricht.

4. Vorrichtung nach Anspruch 2 oder 3, **dadurch gekennzeichnet, dass** die Frequenzen (Fᵢ) der Messsignale (Mᵢ) der Folge über einen Frequenzbereich von 5 kHz bis 120 kHz, bevorzugt einen Frequenzbereich von 10 kHz bis 40 kHz, verteilt sind und einen gegenseitigen Signalabstand (δₛ) zwischen 50 Hz und 600 Hz, bevorzugt zwischen 100 Hz und 360 Hz, haben.

5. Vorrichtung nach einem der Ansprüche 1 bis 4, **dadurch gekennzeichnet, dass** die Steuereinheit (15) dazu ausgebildet ist, die Koppeleinheit (11) so anzusteuern, dass sie jedes Messsignal (Mᵢ) der Folge jeweils über eine vorgegebene zweite Zeitspanne (T_{B}) einkoppelt, welche mehreren Perioden (D) der Netzspannung (V) entspricht, wobei die Auswerteeinheit (13) dazu ausgebildet ist, zu jedem Messsignal (Mᵢ) der Folge die Signalantwort (Aᵢ) jeweils über die genannte zweite Zeitspanne (T_{B}) zu erfassen.

6. Vorrichtung nach Anspruch 5, **dadurch gekennzeichnet, dass** die Auswerteeinheit (13) dazu ausgebildet ist, die zu den Messsignalen (Mᵢ) der Folge erfassten Signalantworten (Aᵢ) mithilfe einer Fourier-Transformation in jeweilige Signalantwortspektren (ASᵢ) zu transformieren.

7. Vorrichtung nach Anspruch 6, **dadurch gekennzeichnet, dass** die Auswerteeinheit (13) ferner dazu ausgebildet ist, die elektrische Leistungsaufnahme (Pₑ) anhand der Scheitelwerte (Wᵢⱼ) der Signalantwortspektren (ASᵢ) zu ermitteln.

8. Vorrichtung nach einem der Ansprüche 5 bis 7, **dadurch gekennzeichnet, dass** die Frequenzen (Fᵢ) der Messsignale (Mᵢ) der Folge über einen Frequenzbereich von 5 kHz bis 120 kHz, bevorzugt einen Frequenzbereich von 10 kHz bis 40 kHz, verteilt sind und einen gegenseitigen Signalabstand (δₛ) von mehreren Kilohertz haben, bevorzugt bei 15 kHz, 20 kHz, 24 kHz, 28 kHz und 32 kHz liegen.

9. Vorrichtung nach einem der Ansprüche 1 bis 8, **dadurch gekennzeichnet, dass** die Steuereinheit (15) ferner dazu ausgebildet ist, die Mittenfrequenz (f_{M}) des Bandpassfilters (14) aufeinanderfolgend auf die Frequenzen (Fᵢ) der Folge von Messsignalen (Mᵢ) einzustellen, ohne die Koppeleinheit (11) zum Einkoppeln eines Messsignals (Mᵢ) anzusteuern, und dass die Auswerteeinheit (13) dazu ausgebildet ist, für jede Mittenfrequenz (f_{M}) jeweils ein Störsignal (Sᵢ) im Haushaltsnetz (3) zu erfassen und zu speichern und beim Ermitteln der elektrischen Leistungsaufnahme (Pₑ) zu berücksichtigen.

10. Vorrichtung nach Anspruch 9, **dadurch gekennzeichnet, dass** die Steuereinheit (15) ferner dazu ausgebildet ist, in der Folge von Messsignalen (Mᵢ) jene Messsignale (Mᵢ) zu überspringen, bei deren Frequenz (Fᵢ) ein Störsignal (Sᵢ) mit einer einen vorgegebenen Grenzwert überschreitenden Signalamplitude erfasst wurde.

11. Vorrichtung nach einem der Ansprüche 1 bis 10, **dadurch gekennzeichnet, dass** die Koppeleinheit (11) einen Signalgenerator (16) zum Erzeugen der Messsignale (Mᵢ) und eine an diesen angeschlossene Koppelschaltung (17) zum Einkoppeln der erzeugten Messsignale (Mᵢ) in den Verbraucheranschluss (8) aufweist.

12. Vorrichtung nach Anspruch 11, **dadurch gekennzeichnet, dass** die Koppelschaltung (17) einen Transformator (18) mit einer an den Verbraucheranschluss (8) anschließbaren Netzseite (18') und einer mit dem Signalgenerator (16), einem ersten Kondensator (19) und einem Messwiderstand (20) in Serie geschalteten Speiseseite (18") aufweist.

13. Vorrichtung nach Anspruch 12, **dadurch gekennzeichnet, dass** der Netzseite (18') des Transformators (18) ein zweiter Kondensator (22) in Serie geschaltet ist.

14. Vorrichtung nach einem der Ansprüche 1 bis 13, **dadurch gekennzeichnet, dass** das Bandpassfilter (14) ein Switched-Capacitor-Filter ist.

## Claims

1. A device (10) for determining the electrical power consumption (Pₑ) of a domestic network (3) connected to a supply network (2) and having a plurality of consumer connections (8), comprising:
a coupling unit (11) which can be connected to one of the consumer connections (8) for coupling in measurement signals (M) into the consumer connection (8),
an evaluation unit (13) connected to the coupling unit (11) for capturing a respective signal response (A) to each coupled-in measurement signal (M) and for determining the electrical power consumption (Pₑ) from the captured signal responses (A), and
a control unit (15) connected to the coupling unit (11) and the evaluation unit (13),
**characterized in that**
the evaluation unit (13) is connected to the coupling unit (11) via a bandpass filter (14) with an adjustable center frequency (f_{M}),
wherein the control unit (15) is connected to the bandpass filter (14) and is configured to control the coupling unit (11) for coupling in a predetermined sequence of measurement signals (Mᵢ) of different frequencies (Fᵢ) into the consumer connection (8) and to adjust the center frequency (f_{M}) of the bandpass filter (14) to the frequency (Fᵢ) of the respectively coupled-in measurement signal (Mᵢ), and
wherein the evaluation unit (13) is configured to determine the electrical power consumption (Pₑ) from the signal responses (Aᵢ) captured for the measurement signals (Mᵢ) of the sequence.

2. The device according to claim 1, **characterized in that** the evaluation unit (13) for capturing the network voltage (V) of the domestic network (3) can be connected to the consumer connection (8) and is configured to respectively capture the signal response (Aᵢ) for each measurement signal (Mᵢ) of the sequence at a time point (τ₁) in which the captured network voltage (V) has a predetermined phase position (PH).

3. The device according to claim 2, **characterized in that** the control unit (15) is configured to control the coupling unit (11) such that it couples in each measurement signal (Mᵢ) of the sequence over only a respective predetermined first time period (T_{A}) which corresponds to a predetermined section, which comprises said phase position (PH), of a period (D) of the network voltage (V).

4. The device according to claim 2 or 3, **characterized in that** the frequencies (Fᵢ) of the measurement signals (Mᵢ) of the sequence are distributed over a frequency range of 5 kHz to 120 kHz, preferably a frequency range of 10 kHz to 40 kHz, and have a reciprocal signal spacing (δₛ) of between 50 Hz and 600 Hz, preferably between 100 Hz and 360 Hz.

5. The device according to any one of claims 1 to 4, **characterized in that** the control unit (15) is configured to control the coupling unit (11) such that it couples in each measurement signal (Mᵢ) of the sequence over a respective predetermined second time period (T_{B}) which corresponds to a plurality of periods (D) of the network voltage (V), wherein the evaluation unit (13) is configured to capture the respective signal response (Aᵢ) to each measurement signal (Mᵢ) of the sequence over said second time period (T_{B}) respectively.

6. The device according to claim 5, **characterized in that** the evaluation unit (13) is configured to transform the signal responses (Aᵢ) captured for the measurement signals (Mᵢ) of the sequence into respective signal response spectra (ASᵢ) using a Fourier transformation.

7. The device according to claim 6, **characterized in that** the evaluation unit (13) is further configured to determine the electrical power consumption (Pₑ) based on the peak values (Wᵢⱼ) of the signal response spectra (ASᵢ).

8. The device according to any one of claims 5 to 7, **characterized in that** the frequencies (Fᵢ) of the measurement signals (Mᵢ) of the sequence are distributed over a frequency range of 5 kHz to 120 kHz, preferably a frequency range of 10 kHz to 40 kHz, and have a reciprocal signal spacing (δₛ) of several kilohertz, preferably lying at 15 kHz, 20 kHz, 24 kHz, 28 kHz and 32 kHz.

9. The device according to any one of claims 1 to 8, **characterized in that** the control unit (15) is further configured to adjust the center frequency (f_{M}) of the bandpass filter (14) successively to the frequencies (Fᵢ) of the sequence of measurement signals (Mᵢ), without triggering the coupling unit (11) to couple in a measurement signal (Mᵢ), and **in that** the evaluation unit (13) is configured to capture and store a respective interference signal (Sᵢ) in the domestic network (3) for each center frequency (f_{M}) and to take it into account when determining the electrical power consumption (Pₑ).

10. The device according to claim 9, **characterized in that** the control unit (15) is further configured to skip those measurement signals (Mᵢ) in the sequence of measurement signals (Mᵢ), at the frequency (Fᵢ) of which an interference signal (Sᵢ) has been captured with a signal amplitude exceeding a predetermined limit value.

11. The device according to any one of claims 1 to 10, **characterized in that** the coupling unit (11) has a signal generator (16) for generating the measurement signals (Mᵢ) and a coupling circuit (17) connected thereto for coupling in the generated measurement signals (Mᵢ) into the consumer connection (8).

12. The device according to claim 11, **characterized in that** the coupling circuit (17) has a transformer (18) with a network side (18'), which can be connected to the consumer connection (8), and a supply side (18") connected in series with the signal generator (16), a first capacitor (19) and a measuring resistor (20).

13. The device according to claim 12, **characterized in that** a second capacitor (22) is connected in series with the network side (18') of the transformer (18).

14. The device according to any one of claims 1 to 13, **characterized in that** the bandpass filter (14) is a switched-capacitor filter.

## Revendications

1. Dispositif (10) pour la détermination d'une consommation électrique (Pₑ) d'un réseau domestique (3) relié à un réseau d'alimentation (2) avec plusieurs raccordements consommateurs (8), comprenant:
une unité d'injection (11) pouvant être raccordée à l'un des raccordements consommateurs (8) pour l'injection de signaux de mesure (M) dans le raccordement consommateur (8),
une unité d'évaluation (13) raccordée à l'unité d'injection (11) pour la détection respectivement d'une réponse de signal (A) pour chaque signal de mesure (M) injecté et pour la détermination de la consommation électrique (Pₑ) à partir des réponses de signal (A) détectées, et
une unité de commande (15) reliée à l'unité d'injection (11) et l'unité d'évaluation (13),
**caractérisé en ce que**
l'unité d'évaluation (13) est raccordée à l'unité d'injection (11) par le biais d'un filtre passe-bande (14) avec une fréquence centrale (f_{M}) réglable,
dans lequel l'unité de commande (15) est reliée au filtre passe-bande (14) et est conçue pour commander l'unité d'injection (11) pour l'injection d'une séquence prédéterminée de signaux de mesure (Mᵢ) de fréquences (Fᵢ) différentes dans le raccordement consommateur (8) et pour régler la fréquence centrale (f_{M}) du filtre passe-bande (14) à la fréquence (Fᵢ) du signal de mesure (Mᵢ) injecté respectivement, et
dans lequel l'unité d'évaluation (13) est conçue pour déterminer la consommation électrique (Pₑ) à partir des réponses de signal (Aᵢ) détectées pour les signaux de mesure (Mᵢ) de la séquence.

2. Dispositif selon la revendication 1, **caractérisé en ce que** l'unité d'évaluation (13) pouvant être raccordée dans le raccordement consommateur (8) pour la détection de la tension de réseau (V) du réseau domestique (3) et est conçue pour détecter, pour chaque signal de mesure (Mᵢ) de la séquence, respectivement la réponse de signal (Aᵢ) à un instant (τᵢ) auquel la tension de réseau (V) détectée possède une position de phase (PH) prédéterminée.

3. Dispositif selon la revendication 2, **caractérisé en ce que** l'unité de commande (15) est conçue pour commander l'unité d'injection (11) de telle sorte qu'elle injecte chaque signal de mesure (Mᵢ) de la séquence respectivement sur seulement un premier intervalle de temps (T_{A}) prédéterminé, lequel correspond à une section prédéterminée, qui comprend ladite position de phase (PH), d'une période (D) de la tension de réseau (V) .

4. Dispositif selon la revendication 2 ou 3, **caractérisé en ce que** les fréquences (Fᵢ) des signaux de mesure (Mᵢ) de la séquence sont distribuées sur une plage de fréquences de 5 kHz à 120 kHz, de préférence sur une plage de fréquences de 10 kHz à 40 kHz, et ont un écart réciproque entre les signaux (δₛ) entre 50 Hz et 600 Hz, de préférence entre 100 Hz et 360 Hz.

5. Dispositif selon l'une des revendications 1 à 4, **caractérisé en ce que** l'unité de commande (15) est conçue pour commander l'unité d'injection (11) de telle sorte qu'elle injecte chaque signal de mesure (Mᵢ) de la séquence respectivement sur un deuxième intervalle de temps (T_{B}) prédéterminé, lequel correspond à plusieurs périodes (D) de la tension de réseau (V), où l'unité d'évaluation (13) est conçue pour détecter respectivement la réponse de signal (Aᵢ) pour chaque signal de mesure (Mᵢ) de la séquence sur ledit deuxième intervalle de temps (T_{B}).

6. Dispositif selon la revendication 5, **caractérisé en ce que** l'unité d'évaluation (13) est conçue pour transformer les réponses de signal (Aᵢ) détectées pour les signaux de mesure (Mᵢ) de la séquence en spectres de réponses de signal (ASᵢ) respectifs à l'aide d'une transformation de Fourier.

7. Dispositif selon la revendication 6, **caractérisé en ce que** l'unité d'évaluation (13) est en outre conçue pour déterminer la consommation électrique (Pₑ) au moyen des valeurs de crête (Wᵢⱼ) des spectres de réponses de signal (ASᵢ).

8. Dispositif selon l'une des revendications 5 à 7, **caractérisé en ce que** les fréquences (Fᵢ) des signaux de mesure (Mᵢ) de la séquence sont distribuées sur une plage de fréquences de 5 kHz à 120 kHz, de préférence sur une plage de fréquences de 10 kHz à 40 kHz, et ont un écart réciproque entre les signaux (δₛ) de plusieurs kilohertz, se situant de préférence à 15 kHz, 20 kHz, 24 kHz, 28 kHz et 32 kHz.

9. Dispositif selon l'une des revendications 1 à 8, **caractérisé en ce que** l'unité de commande (15) est en outre conçue pour régler la fréquence centrale (f_{M}) du filtre passe-bande (14) successivement sur les fréquences (Fᵢ) de la séquence des signaux de mesure (Mᵢ), sans commander à l'unité d'injection (11) d'injecter à un signal de mesure (Mᵢ), et **en ce que** l'unité d'évaluation (13) est conçue, pour chaque fréquence centrale (f_{M}), pour détecter et enregistrer respectivement un signal brouilleur (Sᵢ) dans le réseau domestique (3) et en tenir compte lors de la détermination de la puissance électrique consommée (Pₑ).

10. Dispositif selon la revendication 9, **caractérisé en ce que** l'unité de commande (15) est en outre conçue pour ignorer dans la séquence des signaux de mesure (Mᵢ), ces signaux de mesure (Mᵢ) pour lesquels, à leur fréquence (Fᵢ), un signal brouilleur (Sᵢ) avec une amplitude de signal dépassant une valeur limite prédéterminée a été détecté.

11. Dispositif selon l'une des revendications 1 à 10, **caractérisé en ce que** l'unité d'injection (11) présente un générateur de signaux (16) pour la génération des signaux de mesure (Mᵢ) et un circuit d'injection (17) raccordé à celui-ci pour injecter les signaux de mesure (Mᵢ) générés dans le raccordement consommateur (8).

12. Dispositif selon la revendication 11, **caractérisé en ce que** le circuit d'injection (17) présente un transformateur (18) avec un côté réseau (18') pouvant être raccordé au raccordement consommateur (8) et un côté alimentation (18") connecté en série avec le générateur de signaux (16), un premier condensateur (19) et une résistance de mesure (20).

13. Dispositif selon la revendication 12, **caractérisé en ce qu'**un deuxième condensateur (22) est connecté en série au côté réseau (18') du transformateur (18).

14. Dispositif selon l'une des revendications 1 à 13, **caractérisé en ce que** le filtre passe-bande (14) est un filtre à condensateur commuté.
